# EUROPEAN PATENT APPLICATION

(11) **EP 4 668 037 A1**
(43) Date of publication of application: **24.12.2025**
(21) Application number: 25183777.9
(22) Date of filing: 18.06.2025
(51) Int. Cl.: G05B 19/042, H03K 3/012, H03K 17/18, H03K 19/0175

(54) **MULTI-PURPOSE PROGRAMMABLE I/O CIRCUIT**

(30) Priority: 19.06.2024 US 202463661711 P
(71) Applicant: Vertiv Corporation, Westerville, OH 43082 (US)
(72) Inventor: BALMA, Luigi, 40139 Bologna (IT); COLOMBARI, Paolo, 40141 Bologna (IT); ABDOU, John Ezzat Fahmy, 40024 Bologna (IT); BARBIERI, Mauro, 40139 Bologna (IT)
(74) Representative: Bryn-Jacobsen, Caelia

(57) **Abstract**

A multi-programmable input/output (I/O) circuit is disclosed. A programmable I/O circuit includes a microcontroller and an interface circuit communicatively coupled to one another. The interface circuit includes an input circuit, a pull-up circuit, a pull-down circuit, and a measurement circuit. The microcontroller is configured to generate first and second input signals that are provided to the input, and further configured to receive, on a measurement input, the measurement signal. In response to assertion of the first input signal, the input circuit activates the pull-up circuit to generate a pull-up voltage on an output pin of the interface circuit. In response to assertion of the second input signal, the input circuit activates the pull-down circuit to generate a pull-down voltage on the output pin. The microcontroller may also measure the value of an electrical parameter (e.g., a current or a voltage) based on the measurement signal received from the measurement circuit.

## Description

### PRIORITY

This application claims priority to U.S. Provisional Patent Application Number 63/661,711, entitled "MULTI-PURPOSE PROGRAMMABLE I/O CIRCUIT" AND FILED on June 19, 2024.

### TECHNICAL FIELD

Apparatuses and methods consistent with examples relate to electrical/electronics equipment units, and more particularly circuits for controlling operations of industrial plants.

### BACKGROUND

Many industrial companies utilize different types of electronic control circuits to interface with their respective industrial plants. These requirements may vary from one plant to another, both among different companies as well as within the same company. For example, it may be desirable to drive signals to a contact of a circuit breaker or other apparatus in one type of plant. For another plant, the ability to digitally drive an input may be desired. For a third type of plant, an analog input signal (e.g., for measuring an electrical parameter) may be desired.

### SUMMARY

A multi-programmable input/output (I/O) circuit is disclosed. A programmable I/O circuit according to the disclosure includes a microcontroller and an interface circuit communicatively coupled to one another. The interface circuit includes an input circuit, a pull-up circuit, a pull-down circuit, and a measurement circuit. The microcontroller is configured to generate first and second input signals that are provided to the input, and further configured to receive, on a measurement input, the measurement signal. In response to assertion of the first input signal, the input circuit activates the pull-up circuit to generate a pull-up voltage on an output pin of the interface circuit. In response to assertion of the second input signal, the input circuit activates the pull-down circuit to generate a pull-down voltage on the output pin. The microcontroller may also measure the value of an electrical parameter (e.g., a current or a voltage) based on the measurement signal received from the measurement circuit.

The programmable I/O circuit according to the disclosure may operate in one of a number of different operating modes. In a first mode, the microcontroller may assert the first input signal to cause generation of the pull-up voltage. In a second mode, the microcontroller may assert the second input signal to cause generation of the pull-down voltage. In a third operating mode, the voltage on the output pin may be controlled as a digital value, activating the pull-up or pull-down circuit as necessary to generate the corresponding logic values (e.g., a high voltage as a logic 1 or logic high, a low voltage as a logic 0 or logic low). The microcontroller may use the measurement signal as a feedback signal to determine if the output pin is at the correct logic value and/or within specified limits.

### BRIEF DESCRIPTION OF THE DRAWINGS

The above and/or other aspects will become apparent and more readily appreciated from the following description of examples, taken in conjunction with the accompanying drawings, in which:
FIG. 1 is a block diagram of an I/O including an interface circuit and a microcontroller, according to the principles of the present disclosure.
FIG. 2 is a schematic diagram of an interface circuit, according to the principles of the present disclosure.
FIG. 3 is a block diagram illustrating a system configuration for operating in a pull-up) mode of an I/O circuit, according to the principles of the present disclosure.
FIG. 4 is a block diagram illustrating a system configuration for operating in a measurement (analog) mode of an I/O circuit, according to the principles of the present disclosure.
FIG. 5 is a block diagram illustrating a system configuration for operating in a digital control mode of an I/O circuit, according to the principles of the present disclosure.
FIG. 6 is a sequence diagram illustrating operation in a digital mode with feedback of an I/O circuit, according to the principles of the present disclosure.
FIG. 7 is a flow diagram illustrating operation of a multi-mode I/O circuit, according to the principles of the present disclosure.

### DETAILED DESCRIPTION

Reference will now be made in detail to examples which are illustrated in the accompanying drawings, wherein like reference numerals refer to like elements throughout. In this regard, the examples may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these examples that are obvious to those of ordinary skill in the technical field to which these examples pertain may not be described herein in detail.

It may be understood that the examples described herein may be considered in a descriptive sense only and not for purposes of limitation. Descriptions of features or aspects within each example may be considered as available for other similar features or aspects in other examples.

Industrial plants and components thereof may be controlled by various types of circuits according to specific needs of the plant/components. For example, some industrial plants utilize circuit breakers having an auxiliary contact that is used to monitor its position (open or closed). The contacts may be made using low quality metals, such as silver-nickel, and may be susceptible. Over time, such metal are susceptible to oxidation. This can lead to high resistance in the electrical contacts of a circuit breaker, particularly if its position changes on an infrequent basis. Accordingly, circuits may be designed to monitor these contacts to determine levels oxidation and/or remove the oxidation using electrical current.

In some cases, a particular component in an industrial plant may require digital control. Measurement of particular voltages and/or current may also be a requirement for some components.

The present disclosure is directed to a multipurpose I/O circuit that is programmable such that is can be used in a number of different applications. The circuit of the present disclosure includes a microcontroller that can be programmed/configured for the specific application in which it is utilized. The circuit also includes an interface circuit that is communicatively coupled to the microcontroller. The microcontroller may control operation of the interface circuit using various input signals, and may also perform measurements based on a measurement signal indicative of an electrical parameter, the measurement signal being received from the interface circuit.

In some examples, the interface circuit includes an input circuit, a pull-up circuit, a pull-down circuit, and a measurement circuit. The input circuit is communicatively coupled to receive input signals generated by the microcontroller, and based on respective states of these input signals, control operation of the pull-up and pull-down circuits. The pull-up circuit is configured to, when activated by the input circuit, generate a pull-up voltage on an output pin. The pull-down circuit is configured to, when activated by the input circuit, generate a pull-down voltage on the output pin. The measurement circuit is configured to generate a measurement signal that is indicative of an electrical parameters (e.g., a voltage or a current) on the output pin.

The circuit may operate in different modes. In a first mode of operation, the input circuit may, responsive to assertion of the first input signal (with the second input de-asserted) cause the pull-up circuit to generate a pull-up voltage on the output pin. This mode may be used in any operation where a particular voltage is desired on a component of an industrial plant coupled to the output pin. For example, the output pin may be coupled to a contact of a circuit breaker, and the mode may be used as a countermeasure to oxidation build-up on the contact as well as to determine a current flow through the contact (and possibly, a resistance thereof).

In a second mode of operation, the input circuit may, responsive to assertion of the second input signal (with the first input de-asserted) cause the pull-up circuit to generate a pull-down voltage on the output pin. This mode may be used in, e.g., a situation where a component of an industrial plant generates an undesired voltage or charge on a particular circuit node coupled to the output pin, allowing the undesired voltage to be discharged to ground. More generally, the second mode of operation may be used in any situation where a pull-down voltage is desired on a particular node that may be coupled to the output pin.

In a third mode of operation, the output pin may be controlled as a digital signal, with the microcontroller alternately asserting the first and second input signals to cause logic high and logic low voltages, respectively, on the output pin. This mode may be used when digital control via a particular node is desired.

The I/O circuit according to the disclosure may also operate in a measurement mode in which both the pull-up and pull-down circuits are inactive. During this measurement mode, the measurement circuit may measure an analog value of a signal present on the output pin when not otherwise affected by operation of the interface circuit. This analog value (e.g., a voltage) may be provided to the microcontroller as a measurement signal. This mode may be used to monitor an electrical parameter via the output pin. The microcontroller may, during the monitoring of the output pins, activate one of the pull-up or pull-down circuits based on the voltage of the measurement signal.

In any of the three modes described herein, the microcontroller may conduct measurements of an electrical parameter on the output pin. The electrical parameter may, in some examples, be a voltage, although the voltage may at least in some cases be indicative of a current. The voltage may be detected by the measurement circuit, which is communicatively coupled to provide a measurement signal to a measurement input of the microcontroller.

Various examples of an I/O circuit according to the disclosure are described in further detail herein. It is noted that the various examples are described herein by way of example, but are not intended to limit the scope of the disclosure to any one particular example.

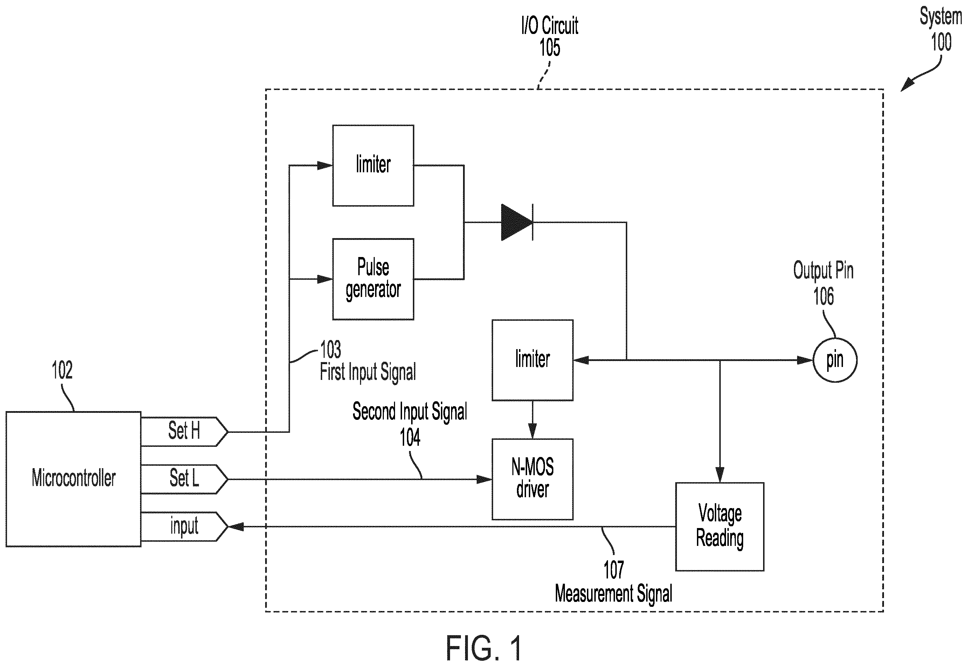

FIG. 1 is a block diagram of an I/O circuit including a microcontroller and an interface circuit, according to the principles of the present disclosure.

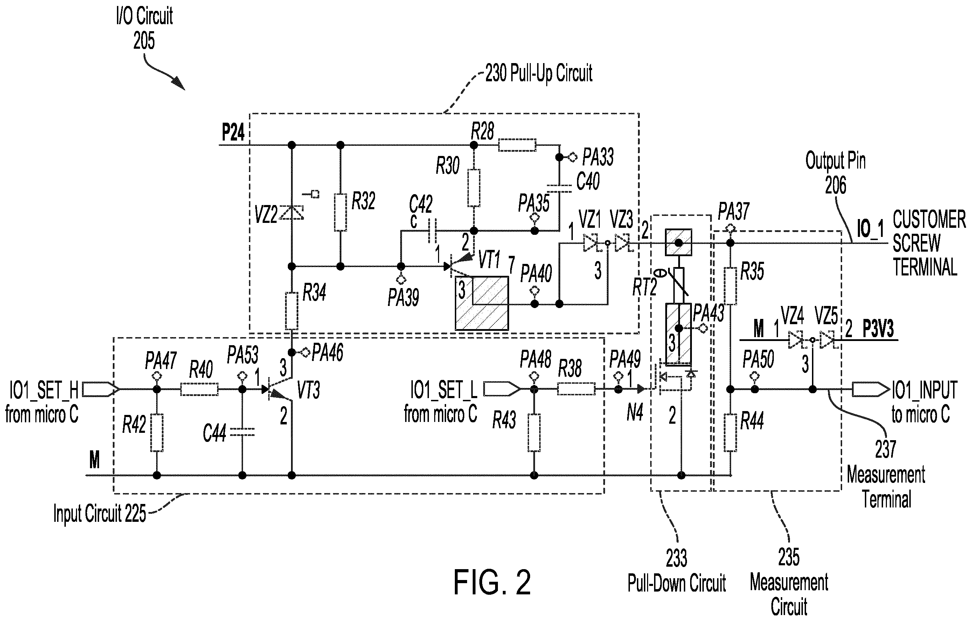

In some examples, I/O circuit 100 includes a microcontroller 102 coupled to an interface circuit 105. In this example, interface circuit 105 may generate a pull-up voltage (using a pull-up circuit, described herein) to cause a current between two different values (40 mA and 10 mA in this non-limiting example) to flow through the contact coupled to output pin 106. In one example application, these currents may be used to both reduce or eliminate any oxidation that may have occurred on the contact of a circuit breaker, as well as to provide a basis of measurement to ascertain that the resistance of the contact is within specifications. Microcontroller 102 may also cause a pull-down voltage to be generated on the output pint 106 by asserting the second input signal 104 and thus causing activation of a pull-down circuit (as described herein). An electrical parameter may be measured by microcontroller 102 on a measurement input that is coupled to receive a measurement signal 107. The various labeled blocks in FIG. 1 (e.g., limiter, pulse generator, etc.) are discussed in further detail with reference to FIG. 2.

FIG. 2 is a schematic diagram of an interface circuit, according to the principles of the present disclosure. In some examples, interface circuit 205 includes an input circuit 225, a pull-up circuit 230, a pull-down circuit 233, and a measurement circuit 235. Input circuit may be configured to receive a first input signal (shown here as IO1_SET_H) from a microcontroller that, when asserted, causes pull-up circuit 230 to generate a voltage on output pin 206. Measurement circuit 235 may generate, on measurement terminal 237, a measurement signal that may be provided to the microcontroller used to determine an electrical parameter on output pin, such as the current flowing through a contact coupled thereto. Interface circuit 205 may be used with, e.g., a microcontroller such as microcontroller 102 of FIG. 1 in the same or similar configuration.

Input circuit 225 may include resistors R40 and R42, capacitor C44, and a transistor VT3. In some examples, transistor VT3 is a bipolar transistor, and more particularly, and NPN transistor. When the first input signal is asserted, VT3 may draw current though its collector terminal, and thus generating a pull-down path through R34 of pull-up circuit 230. When the first input signal is de-asserted, the voltage on the base terminal of transistor VT3 may be such that the device is in cutoff, with no current flowing between its collector and emitter.

Pull-up circuit 230 may include resistors R28, R30, R32, and R34, capacitors C40 and C42, diodes VZ1, VZ2, and VZ3 (Zener diodes in this implementation), and transistor VT1. As shown here, transistor VT1 is a bipolar PNP transistor. It is noted however that examples are possible and contemplated in which other types of transistors are used in interface circuit 205. For example, examples in which VT1 is implemented as a PMOS transistor while VT3 is implemented as an NMOS transistor are possible and contemplated.

When transistor VT3 generates the pull-down path through R34, the voltage on the junction of R34 and the base of VT1 may fall. When the voltage on its base falls sufficiently, VT1 may become forward biased, with a pull-up path being generated through its collector and emitter terminals. This in turn generates a voltage on output pin 206 that causes current to flow through a contact of a circuit breaker to which this terminal is coupled.

When initially activated, pull-up circuit 230 may implement the function of a pulse generator, generating the voltage on output pin 206 at a first voltage value, thereby causing current to flow at a first current value. During the time that the first input signal is asserted, capacitors C40 and C42 will discharge, and thus the voltage on output pin 206 will decrease. Correspondingly, the current generated via output pin 206 will also decrease until it reaches a second current value. This second current value may be a steady-state value, and may remain as such until the first input signal is de-asserted. Accordingly, the capacitors C40 and C42 perform a limiter function.

When the first input signal is de-asserted and VT3 enters cutoff, the voltage on the base of VT1 may rise sufficiently to cause that device to also enter cutoff. Thereafter, the pull-up path is no longer present, and thus no further current is generated by a voltage on output pin 206. Meanwhile, with VT1 and VT3 in cutoff, capacitors C40 and C42 are charged by a supply voltage on node P24, via resistors R28 and R30. The charge on capacitor C42 may cause VT1 to remain in cutoff until the next activation of VT3. Meanwhile, the charge on C40 may be stored until VT3 is active, discharging thereafter to vary the voltage on output pin 206.

Input circuit 225 may include resistors R38 and R43, the junction of which is coupled to receive a second input signal (labeled here as IO1_SET_L) that, when asserted, cause activation of pull-down circuit 233. Pull-down circuit 233 as shown here includes an NMOS transistor N4 (an NMOS driver) having a gate terminal coupled to the terminal of R38 opposite that which is coupled to R43. The drain terminal of N4 is electrically coupled to variable resistor RT2 (a limiter resistor), which in turn is coupled to output pin 206, while the source terminal is coupled to a ground node. When the second input signal is asserted, N4 becomes active and generates a pull-down path between output pin 206 and the ground node. This in turn causes any voltage present on output pin 206 to be pulled low towards ground.

Measurement circuit 235 as shown here includes Zener diodes VZ4 and VZ5 and a voltage divider circuit (for voltage reading) comprising resistors R35 and R44, which are coupled in series between output pin 206 and a ground node. At the junction of R35 and R44 is a measurement terminal where a measurement signal is generated as a voltage, with the generated voltage corresponding to the current flowing through the contact of the circuit breaker and output pin 206. This measurement signal may be provided to the microcontroller to determine the current through the contact. In some examples, the measurement may be performed near the end of the predetermined time, just prior to the microcontroller de-asserting the first input signal. However, examples are possible and contemplated in which the microcontroller provides a continuous measurement of the current in order to determine the response of pull-up circuit 230 and the current through the correspondingly coupled contact of the circuit breaker.

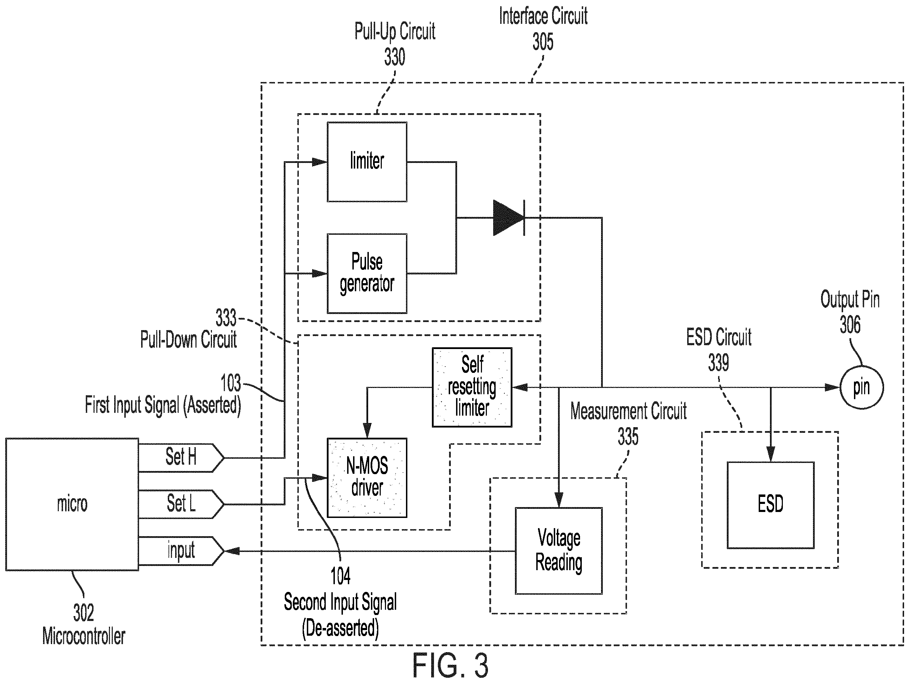

FIG. 3 is a block diagram illustrating a system configuration for operating in a first mode of an I/O circuit, according to the principles of the present disclosure. More particularly, FIG. 3 illustrates operation in a mode in which a pull-up voltage is generated on output pin 306. In this particular mode, first input signal 103 is asserted while second input signal 104 remains de-asserted. Accordingly, pull-up circuit 330 is activated while pull-down circuit 333 remains inactive. This results in a pull-up voltage being generated on output pin 306. In some examples, an initial current pulse of 40 mA is generated, with this current eventually decaying to 10 mA, with these current being drawn via output pint 306 from, e.g., a contact coupled thereto. It is noted however that these current values are provided by way of example and are not intended to be limiting. It is further noted that while a current pulse is generated in this particular example, examples in which the electrical parameter generated on output pin 306 remains substantially the same throughout activation of pull-up circuit 330 are possible and contemplated. During operation in this mode, microcontroller 302 may perform measurements of the voltage present on output pint 306 using a measurement signal provided from measurement circuit 335. The measurement signal may be received in the form of a voltage, but may correspond to a current flowing through output pin 306.

In some examples, interface circuit 305 also includes an ESD (electrostatic discharge) protection circuit 339. ESD circuit 339 may protect various components of interface circuit 305, such as NMOS transistor N4.

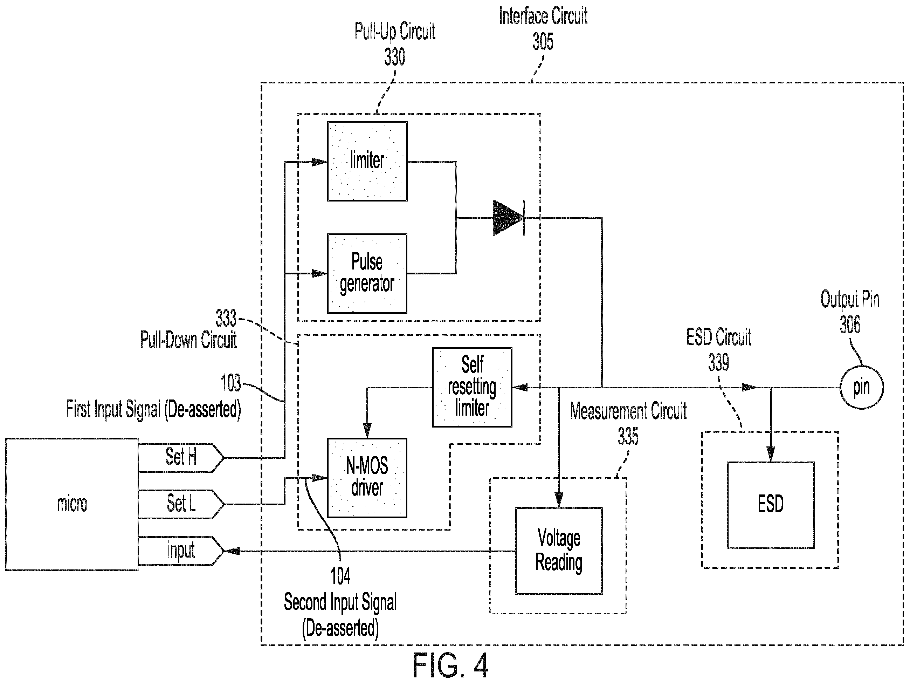

FIG. 4 is a block diagram illustrating a system configuration for operating in a measurement (analog) mode of an I/O circuit, according to the principles of the present disclosure. Both the first and second input signals may be de-asserted, thereby causing the pull-up circuit 330 and pull-down circuit 333, respectively, to be inactive. However, measurement circuit 335 may provide a measurement signal 307 (in the form of an analog voltage in this example) to microcontroller 302. The measurement signal 307 may be indicative of an electrical parameter present on output pin 306. Furthermore, since both pull-up circuit 330 and pull-down circuit 333 are inactive in this mode, the value of the electrical parameter is largely unaffected by interface circuit 305.

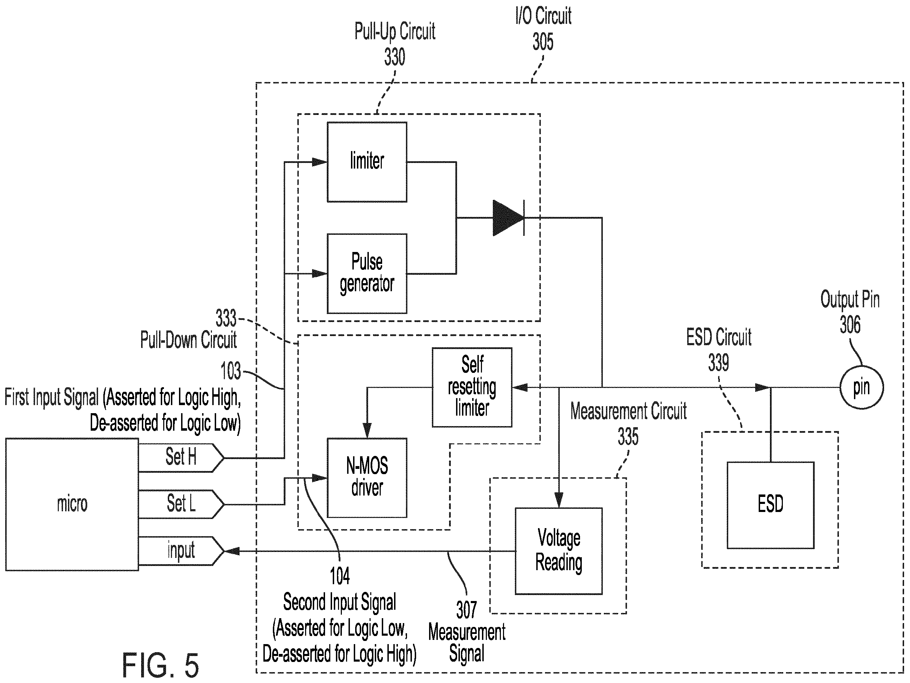

FIG. 5 is a block diagram illustrating a system configuration for operating in a digital control mode of an I/O circuit, according to the principles of the present disclosure. When operating in the digital control mode, microcontroller 302 may assert the first input signal 103 to generate a logic high on output node 306. The second input signal 104 may remain de-asserted when a logic high is desired. The logic high on the output pin 306 in this configuration is a result of the activation of pull-up circuit 330 while pull-down circuit 333 remains inactive.

Microcontroller 302 may assert the second input signal 104 and de-assert the first input signal 103 to cause a logic low to be driven onto output pin 306. The logic low is the result of activating the pull-down circuit while the pull-up circuit is inactive. It is noted that the signal configuration for generating the logic low may also correspond to the signal configuration used when operating in a pull-down mode.

Microcontroller 302 may monitor the operation of interface circuit 305 using measurement circuit 335 to ensure that the logic high or logic low are reflected on the output pin per the input signal configuration. Although not shown here, microcontroller 302 may also have one or more additional inputs to provide feedback used in determining whether output pin 306 is to be driven to a logic high value or a logic low value.

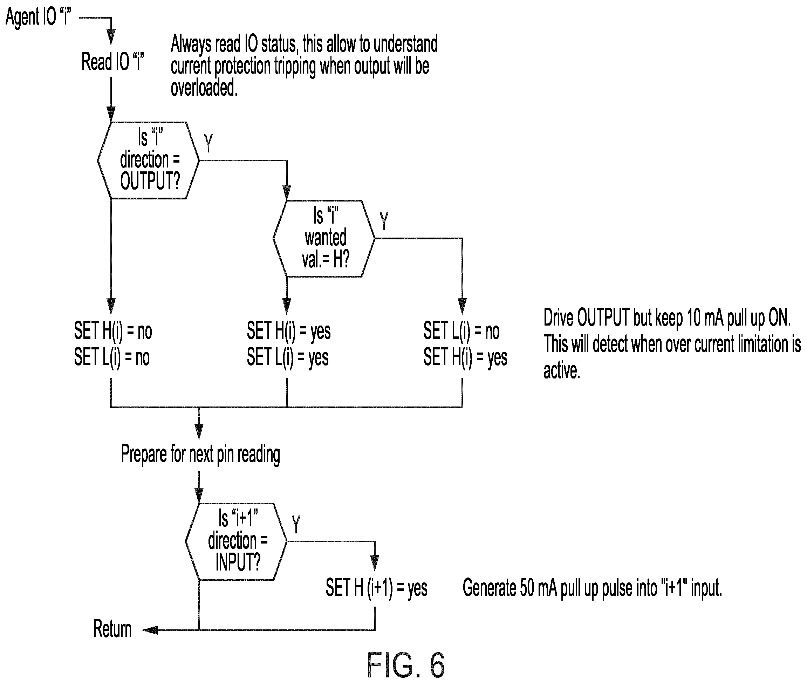

FIG. 6 is a sequence diagram illustrating operation in the digital control mode of an I/O circuit, according to the principles of the present disclosure. For example, operation of the pull-up and pull-down circuits is conducted in conjunction with the measurement circuit, which provides a measurement signal as feedback to ensure that the signal on the output pin is actually assuming the desired value. As shown in FIG. 6, the sequence may step through various comparison operations, with the microcontroller setting/adjusting the state of the input signals (e.g., SET H(i), or first input signal, SET L(i), or second input signal) in accordance with the comparisons. After reading for a particular value "i" (which may be a cycle in time or a contact on equipment when the output pin is movable), the sequence may progress to a next value "i" ("i+1").

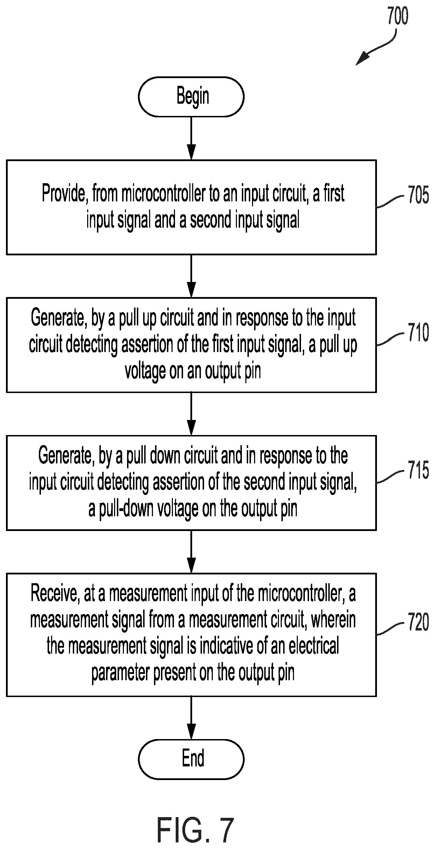

FIG. 7 is a flow diagram illustrating operation of a multi-mode I/O circuit, according to the principles of the present disclosure. Method 700 may be performed by various examples of an I/O circuit as described herein. Examples of an I/O circuit not explicitly described herein but otherwise capable of carrying out Method 700 are also considered to fall within the scope of this disclosure.

Method 700 includes providing, from microcontroller to an input circuit, a first input signal and a second input signal (block 705). The method further includes generating, by a pull-up circuit and in response to the input circuit detecting assertion of the first input signal, a pull-up voltage on an output pin (block 710). The method further includes generating, by a pull-down circuit and in response to the input circuit detecting assertion of the second input signal, a pull-down voltage on the output pin (block 715). The method further includes receiving, at a measurement input of the microcontroller, a measurement signal from a measurement circuit, wherein the measurement signal is indicative of an electrical parameter present on the output pin (block 720).

Further examples are set out in the clauses below:
1. An apparatus comprising:
   a microcontroller; and
   an interface circuit in communication with the microcontroller, wherein the interface circuit includes:
      an input circuit coupled to receive first and second input signals from the microcontroller;
      a pull-up circuit configured to cause a pull-up voltage to be generated on an output pin in response to assertion of, by the microcontroller onto a first input of the input circuit, the first input signal;
      a pull-down circuit configured to cause a pull-down voltage to be generated on the output pin in response to assertion, by the microcontroller onto a second input of the input circuit, the second input signal; and
      a measurement circuit configured to provide a measurement signal to a measurement input of the microcontroller based on a voltage present on the output pin.
2. The apparatus of clause 1, wherein the interface circuit is configured to:
   operate in a first mode, wherein, during operation in the first mode, the pull-up circuit is configured to generate the pull-up voltage on a contact coupled to the output pin;
   operate in a second mode, wherein, during operation in the second mode, the measurement circuit is configured to determine a value of an electrical parameter present on the output pin; and
   operate in a third mode to control a corresponding voltage on the output pin as a digital value, wherein, during operation in the third mode, wherein the digital value is a logic high in response to the microcontroller asserting the first input signal, and wherein the digital value is a logic low in response to the microcontroller asserting the second input signal.
3. The apparatus of clause 1 or 2, wherein the input circuit includes:
   a first transistor configured to be activated in response to assertion of the first input signal; and
   a resistor network coupled to receive the second input signal, wherein the resistor network is coupled to the pull-down circuit.
4. The apparatus of clause 3, wherein the pull-up circuit includes a second transistor, wherein the first transistor is configured to generate a pull-down path between a control terminal of the second transistor and a ground node, and wherein, in response to generation of the pull-down path between the control terminal and the ground node, the second transistor is configured to activate to cause generation of a pull-up voltage on the output pin.
5. The apparatus of clause 4, wherein the pull-down circuit includes a third transistor configured to generate, in response to assertion of the second input signal, a pull-down path between the output pin and the ground node.
6. The apparatus of clause 5, wherein the first and second transistors are bipolar transistors, and wherein the third transistor is an NMOS transistor.
7. The apparatus of clause 4, wherein the pull-up circuit includes a first capacitor configured to inhibit activation of the second transistor when the first transistor is inactive, and further includes a second capacitor configured to discharge through the second transistor when the second transistor is active.
8. The apparatus of clause 2, wherein the measurement circuit includes a voltage divider having first and second resistors coupled in series between a pull-up terminal and a ground terminal, wherein a measurement terminal is coupled to a junction of the first and second resistors and further coupled to the measurement input of the microcontroller.
9. The apparatus of clause 8, wherein the pull-up circuit is configured to generate a first electrical current followed by a second electrical current, and wherein the microcontroller is configured to determine at least the second electrical current based on a voltage present on the measurement terminal.
10. The apparatus of clause 8, wherein, during operation in the third mode, the microcontroller is configured to determine if the output pin is at a desired voltage based on a measurement of the voltage present on the measurement terminal.
11. A method comprising:
   providing, from microcontroller to an input circuit, a first input signal and a second input signal;
   generating, by a pull-up circuit and in response to the input circuit detecting assertion of the first input signal, a pull-up voltage on an output pin;
   generating, by a pull-down circuit and in response to the input circuit detecting assertion of the second input signal, a pull-down voltage on the output pin; and
   receiving, at a measurement input of the microcontroller, a measurement signal from a measurement circuit, wherein the measurement signal is indicative of an electrical parameter present on the output pin.
12. The method of clause 11, further comprising:
   operating in a first mode, wherein operating in the first mode comprises the pull-up circuit generating a pull-up voltage on a contact coupled to the output pin;
   operating in a second mode, wherein operating in the second mode comprises the measurement circuit is configured to determine a value of an electrical parameter present on the output pin; and
   operating in a third mode to control a corresponding voltage on the output pin as a digital value, wherein, during operation in the third mode, the digital value is a logic high in response to the microcontroller asserting the first input signal, and wherein the digital value is a logic low in response to the microcontroller asserting the second input signal.
13. The method of clause 11 or 12 further comprising:
   activating a first transistor, of the input circuit, in response to assertion of the first input signal; and
   receiving, at a resistor network coupled to the pull-down circuit, the second input signal.
14. The method of clause 13, further comprising:
   generating, using the first transistor, a pull-down path between a control terminal of a second transistor and a ground node;
   activating the second transistor in response to generation of the pull-down path; and
   generating a pull-up voltage on the output pin in response to activating the second transistor.
15. The method of clause 14, further comprising generating a pull-down path, using a third transistor or the pull-down circuit, between the output pin and the ground node.
16. The method of clause 14 or 15, further comprising:
   inhibiting activation of the second transistor, using a first capacitor of the pull-up circuit, when the first transistor is inactive; and
   discharging a second capacitor of the pull-up circuit, through the second transistor when the second transistor is active.
17. The method of any one of clauses 12-16, further comprising:
   generating, using the pull-up circuit, a first electrical current followed by a second electrical current;
   determining, using the microcontroller, at least the second electrical current based on a voltage present on the measurement input; and
   determining, using the microcontroller, if the output pin is at a desired voltage based on a measurement of the voltage present on the measurement input.
18. A system comprising:
   a microcontroller configured to assert a first input signal and a second input signal;
   an interface circuit configured to operate in a first mode and a second mode, wherein the interface circuit is coupled to the microcontroller and includes:
      an input circuit coupled to receive the first input signal and the second input signal from the microcontroller;
      a pull-up circuit configured to, during operation in the first mode, cause a pull-up voltage to be generated on an output pin of the interface circuit in response to assertion of the first input signal;
      a pull-down circuit configured to cause a pull-down voltage to be generated on the output pin in response to assertion, by the microcontroller onto a second input of the input circuit, the second input signal; and
      a measurement circuit configured to, during operation in the second mode, provide a measurement signal to a measurement input of the microcontroller based on a voltage present on the output pin.
19. The system of clause 18, wherein the input circuit includes:
   a first transistor configured to be activated in response to assertion of the first input signal; and
   a resistor network coupled to receive the second input signal, wherein the resistor network is coupled to the pull-down circuit.
20. The system of clause 19, wherein the pull-up circuit includes a second transistor, wherein the first transistor is configured to generate a pull-down path between a control terminal of the second transistor and a ground node, and wherein, in response to generation of the pull-down path between the control terminal and the ground node, the second transistor is configured to activate to cause generation of a pull-up voltage on the output pin;
   wherein the pull-down circuit includes a third transistor configured to generate, in response to assertion of the second input signal, a pull-down path between the output pin and the ground node; and
   wherein the first and second transistors are bipolar transistors, and wherein the third transistor is an NMOS transistor.

While examples have been described with reference to the figures, it will be understood by those of ordinary skill in the art that various changes in form and details may be made therein without departing from the scope as defined by the following claims.

## Claims

1. An apparatus comprising:
a microcontroller; and
an interface circuit in communication with the microcontroller, wherein the interface circuit includes:
an input circuit coupled to receive first and second input signals from the microcontroller;
a pull-up circuit configured to cause a pull-up voltage to be generated on an output pin in response to assertion of, by the microcontroller onto a first input of the input circuit, the first input signal;
a pull-down circuit configured to cause a pull-down voltage to be generated on the output pin in response to assertion, by the microcontroller onto a second input of the input circuit, the second input signal; and
a measurement circuit configured to provide a measurement signal to a measurement input of the microcontroller based on a voltage present on the output pin.

2. The apparatus of claim 1, wherein the interface circuit is configured to:
operate in a first mode, wherein, during operation in the first mode, the pull-up circuit is configured to generate the pull-up voltage on a contact coupled to the output pin;
operate in a second mode, wherein, during operation in the second mode, the measurement circuit is configured to determine a value of an electrical parameter present on the output pin; and
operate in a third mode to control a corresponding voltage on the output pin as a digital value, wherein, during operation in the third mode, wherein the digital value is a logic high in response to the microcontroller asserting the first input signal, and wherein the digital value is a logic low in response to the microcontroller asserting the second input signal.

3. The apparatus of claim 1 or 2, wherein the input circuit includes:
a first transistor configured to be activated in response to assertion of the first input signal; and
a resistor network coupled to receive the second input signal, wherein the resistor network is coupled to the pull-down circuit.

4. The apparatus of claim 3, wherein the pull-up circuit includes a second transistor, wherein the first transistor is configured to generate a pull-down path between a control terminal of the second transistor and a ground node, and wherein, in response to generation of the pull-down path between the control terminal and the ground node, the second transistor is configured to activate to cause generation of a pull-up voltage on the output pin.

5. The apparatus of claim 4, wherein the pull-down circuit includes a third transistor configured to generate, in response to assertion of the second input signal, a pull-down path between the output pin and the ground node.

6. The apparatus of claim 5, wherein the first and second transistors are bipolar transistors, and wherein the third transistor is an NMOS transistor.

7. The apparatus of claim 4, wherein the pull-up circuit includes a first capacitor configured to inhibit activation of the second transistor when the first transistor is inactive, and further includes a second capacitor configured to discharge through the second transistor when the second transistor is active.

8. The apparatus of claim 2, wherein the measurement circuit includes a voltage divider having first and second resistors coupled in series between a pull-up terminal and a ground terminal, wherein a measurement terminal is coupled to a junction of the first and second resistors and further coupled to the measurement input of the microcontroller.

9. The apparatus of claim 8, wherein the pull-up circuit is configured to generate a first electrical current followed by a second electrical current, and wherein the microcontroller is configured to determine at least the second electrical current based on a voltage present on the measurement terminal.

10. The apparatus of claim 8, wherein, during operation in the third mode, the microcontroller is configured to determine if the output pin is at a desired voltage based on a measurement of the voltage present on the measurement terminal.

11. A method comprising:
providing, from microcontroller to an input circuit, a first input signal and a second input signal;
generating, by a pull-up circuit and in response to the input circuit detecting assertion of the first input signal, a pull-up voltage on an output pin;
generating, by a pull-down circuit and in response to the input circuit detecting assertion of the second input signal, a pull-down voltage on the output pin; and
receiving, at a measurement input of the microcontroller, a measurement signal from a measurement circuit, wherein the measurement signal is indicative of an electrical parameter present on the output pin.

12. The method of claim 11, further comprising:
operating in a first mode, wherein operating in the first mode comprises the pull-up circuit generating a pull-up voltage on a contact coupled to the output pin;
operating in a second mode, wherein operating in the second mode comprises the measurement circuit is configured to determine a value of an electrical parameter present on the output pin; and
operating in a third mode to control a corresponding voltage on the output pin as a digital value, wherein, during operation in the third mode, the digital value is a logic high in response to the microcontroller asserting the first input signal, and wherein the digital value is a logic low in response to the microcontroller asserting the second input signal.

13. The method of claim 11 or 12, further comprising:
activating a first transistor, of the input circuit, in response to assertion of the first input signal; and
receiving, at a resistor network coupled to the pull-down circuit, the second input signal; and optionally
further comprising:
generating, using the first transistor, a pull-down path between a control terminal of a second transistor and a ground node;
activating the second transistor in response to generation of the pull-down path; and
generating a pull-up voltage on the output pin in response to activating the second transistor.

14. The method of claim 13, further comprising generating a pull-down path, using a third transistor or the pull-down circuit, between the output pin and the ground node; or optionally
further comprising:
inhibiting activation of the second transistor, using a first capacitor of the pull-up circuit, when the first transistor is inactive; and
discharging a second capacitor of the pull-up circuit, through the second transistor when the second transistor is active.

15. The method of claim 12, further comprising:
generating, using the pull-up circuit, a first electrical current followed by a second electrical current;
determining, using the microcontroller, at least the second electrical current based on a voltage present on the measurement input; and
determining, using the microcontroller, if the output pin is at a desired voltage based on a measurement of the voltage present on the measurement input.
